# EUROPEAN PATENT SPECIFICATION

(11) **EP 2 955 848 B1**
(45) Date of publication and mention of the grant of the patent: **07.06.2017**
(21) Application number: 15162878.1
(22) Date of filing: 09.04.2015
(51) Int. Cl.: H05K 1/02, H02H 3/087, H02H 5/04, H02H 7/22, H03K 17/0812, F02P 19/02, F02D 41/28, H05K 1/18, H02H 3/08, H03K 17/08

(54) **CONTROL APPARATUS**
STEUERUNGSVORRICHTUNG
APPAREIL DE CONTRÔLE

(30) Priority: 23.04.2014 JP 2014088941
(43) Date of publication of application: 16.12.2015
(73) Proprietor: NGK Spark Plug Co., Ltd., Nagoya-shi, Aichi 467-8525 (JP)
(72) Inventor: Kumazawa, Shinji, Nagoya, Aichi 467-8525 (JP); Toda, Satoru, Nagoya, Aichi 467-8525 (JP); Kawagishi, Wataru, Nagoya, Aichi 467-8525 (JP); Nakano, Hitoshi, Nagoya, Aichi 467-8525 (JP)
(74) Representative: Grünecker Patent- und Rechtsanwälte PartG mbB

(56) References cited:
- EP-A1- 1 811 819
- GB-A- 2 300 340
- US-A1- 2007 103 006
- US-B1- 6 445 277

## Description

### [Technical Field]

The present invention relates to a control apparatus in which an IC package or the like including a semiconductor switch is disposed on a printed circuit board.

### [Background Art]

Patent Document 1 discloses a control apparatus which includes a transistor switch for driving a heater element of an automobile such as a glow plug, and a control circuit for controlling the transistor switch. In this control apparatus, an overheat protection element whose contact connection is cancelled when its temperature exceeds a limiting temperature is provided on at least one of the high side (high voltage side) and the low side (low voltage side) of the transistor switch. The overheat protection element is configured such that the electrical connection between conductor members is formed by means of soldering, and a mechanical stress (e.g., spring force) is applied to the electrically connected portion. When the temperature exceeds the limiting temperature, the solder melts and the electrical connection is broken by the spring force.

According to the technique of Patent Document 1, when the temperature of the control apparatus becomes high as a result of occurrence of a failure in the transistor switch or the control circuit therefore, the electrical connection in the overheat protection element is broken, whereby overheating of the control apparatus can be prevented.

An abnormality detection apparatus with which the power supply to an electrical load provided in an automobile is controlled, is for instance known from US 2007/103006 A1. The respective abnormality detection apparatus is provided on a downstream side of the load and connected between the load and ground potential. In said abnormality detection apparatus, a constant current control circuit and an overheat interruption circuit are provided.

In particular, via the overheat interruption circuit, the current which flows through the load to ground is interrupted by a logic element provided in the overheat interruption circuit.

A circuit board having an array of sensors arranged in a matrix form is disclosed in EP 1 811 819 A1. A respective temperature control of the sensors is provided by melting fuses which are connected to a voltage supply. If a sensor overheats, the respective fuse is fused, wherein a respective voltage signal is generated for identification of the location of the overheated sensor. A heat protection for electrical components is likewise described in GB 2 300 340 A.

### [Prior Art Document]

### [Patent Document]

[Patent Document 1] Japanese *Kohyo* (PCT) Patent Publication No. 2008-530727

### [Summary of the Invention]

### [Problems to be Solved by the Invention]

The inventors of the present invention found that, when a semiconductor switch (transistor) breaks, there arises a possibility that an unintentional current path is formed between the broken semiconductor switch and a signal ground of the control apparatus (ground for control signals), and an excessively large current flows therethrough. Also, the inventors found that there is a possibility that the insulating layer of the printed circuit board is carbonized by the heat generated from the broken semiconductor switch, and the carbonized insulating layer forms a short circuit between a current path trace of the semiconductor switch and the signal ground of the printed circuit board, whereby an excessively large current flows therebetween.

### [Means for Solving the Problems]

The present invention has been accomplished so as to solve the above-described problems, and the present invention can be realized as the following modes.

(1) According one mode of the present invention, there is provided a control apparatus in which a switch IC is disposed on a printed circuit board. The switch IC is an IC package including a semiconductor switch, and is provided on a high-voltage side of a resistive load so as to drive the resistive load. The printed circuit board has a signal ground connection wiring formed thereon. In this control apparatus, an overheat prevention component and an overcurrent prevention component are provided. The overheat prevention component is connected to the switch IC, and includes a first element having a function of interrupting or limiting current flowing through the switch IC in response to temperature rise. The overcurrent prevention component is connected to the signal ground connection wiring, and includes a second element having a function of interrupting overcurrent.
   According to this configuration, even when a failure occurs in the switch IC, overheating of the switch IC can be prevented by the action of the overheat prevention component. Also, even in the case where a path through which large current may flow is formed between the semiconductor switch and the signal ground of the printed circuit board as a result or a failure of the semiconductor switch, by the action of the overcurrent prevention component, an excessively large current is prevented from flowing to the signal ground.
(2) In the above-described control apparatus, a plurality of the switch ICs may be disposed on the printed circuit board such that no switch IC is present between any of the switch ICs and the overheat prevention component.
   According to this configuration, irrespective of which one of the switch IC breaks, overheating of the broken switch IC can be prevented to the same degree by the overheat prevention component.
(3) In the above-described control apparatus, when the plurality of switch ICs and the overheat prevention component are projected in the thickness direction of the printed circuit board, the plurality of switch ICs may be disposed such that the center of each switch IC is present within a circle whose center coincides with the center of the overheat prevention component and whose radius is (0.5·L1 + 1.5·L2), where L1 is the dimension of the overheat prevention component in the longitudinal direction thereof, and L2 is the dimension of each switch IC in the longitudinal direction thereof.
   According to this configuration, the distance between each switch IC and the overheat prevention component is limited to a short range. Therefore, overheating of each switch IC can be prevented more reliably.

Notably, the present invention can be realized in various forms. For example, the present invention can be realized as a control apparatus, a method for manufacturing a control apparatus, or a method for disposing electronic components.

### [Brief Description of the Drawings]

[FIG. 1] Plan view of a control apparatus which is one embodiment.
[FIG. 2] Block diagram showing the circuit configuration of the control apparatus.
[FIG. 3] Explanatory graph showing an example of change in the temperature of a switch IC.
[FIG. 4] Explanatory diagram showing a state in which a current path through which overcurrent may flow is formed.
[FIG. 5] Explanatory view showing an example of a preferred layout condition of switch ICs and a thermal fuse.
[FIG. 6(A)] Explanatory view showing an example in which two switch ICs are disposed at positions which are in line symmetry and rotational symmetry with respect to a single thermal fuse.
[FIG. 6(B)] Explanatory view showing an example in which two switch ICs are disposed at positions which are in line symmetry with respect to a single thermal fuse.
[FIG. 7(A)] Explanatory view showing an example in which three switch ICs are disposed at positions which are in line symmetry and rotational symmetry with respect to a single thermal fuse.
[FIG. 7(B)] Explanatory view showing an example in which three switch ICs are disposed at positions which are in line symmetry with respect to a single thermal fuse.
[FIG. 8(A)] Explanatory view showing an example in which four switch ICs are disposed at positions which are in line symmetry with respect to a single thermal fuse.
[FIG. 8(B)] Explanatory view showing an example in which four switch ICs are disposed at positions which are in rotational symmetry with respect to a single thermal fuse.
[FIG. 9(A)] Explanatory view showing an example in which four switch ICs are disposed at positions which are in line symmetry with respect to two thermal fuses.
[FIG. 9(B)] Explanatory view showing an example in which four switch ICs are disposed at positions which are in line symmetry with respect to two thermal fuses.
[FIGS. 10(A) and 10(B)] Plan and front views of a control apparatus which is another embodiment of the present invention.
[FIGS. 11(A) and 11(B)] Plan and front views of a control apparatus which is still another embodiment of the present invention.
[FIGS. 12(A) and 12(B)] Plan and front views of a control apparatus which is still another embodiment of the present invention.
[FIG. 13] Block diagram of a control apparatus which is still another embodiment of the present invention.

### [Modes for Carrying out the Invention]

### A. Overall Configuration of Control Apparatus

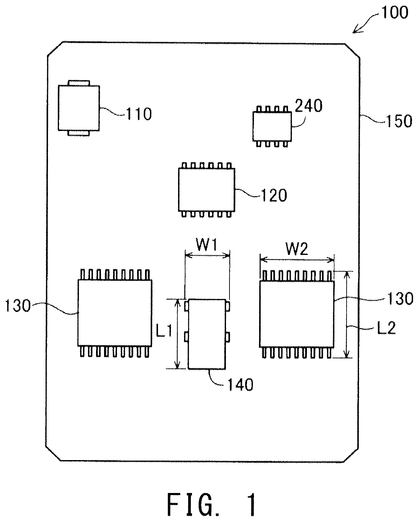

FIG. 1 is a plan view of a control apparatus 100 which is one embodiment of the present invention. This control apparatus 100 is configured as an apparatus for controlling a resistive load (e.g., a glow plug) for an automobile. This control apparatus 100 has a structure in which a power supply circuit 110, a controller IC 120, two switch ICs 130, a thermal fuse 140, a current fuse 240 are disposed on a printed circuit board 150. The thermal fuse 140 is disposed at a position between the two switch ICs 130. Notably, although the control apparatus 100 includes electronic components other than the above-mentioned components, wiring traces, and various terminals, these are not shown in FIG. 1.

Each of the power supply circuit 110, the controller IC 120, and the switch ICs 130 is an electronic component constituted by an IC package. In the example of FIG. 1, the five types of components 110, 120, 130, 140, and 240 are configured as surface-mount-type packages. Each of the switch ICs 130 is an IC package including a semiconductor switch (e.g., an FET). However, it is preferred that each of the switch ICs 130 be an IC package called IPD (Intelligent Power Device) which includes not only a semiconductor switch but also a control circuit for the semiconductor switch (e.g., an FET gate drive circuit) and an overheat protection circuit.

In the example of FIG. 1, the dimension of the thermal fuse 140 in the longitudinal direction thereof is L1, and the dimension of the thermal fuse 140 in the lateral direction (width direction) thereof is W1. The dimension of each switch IC 130 in the longitudinal direction thereof is L2, and the dimension of each switch IC 130 in the lateral direction (width direction) thereof is W2. In general, L1 < L2 and W1 < W2. The longitudinal and lateral dimensions of each package are those of the contour of the entire package including both a mold portion and lead wires thereof.

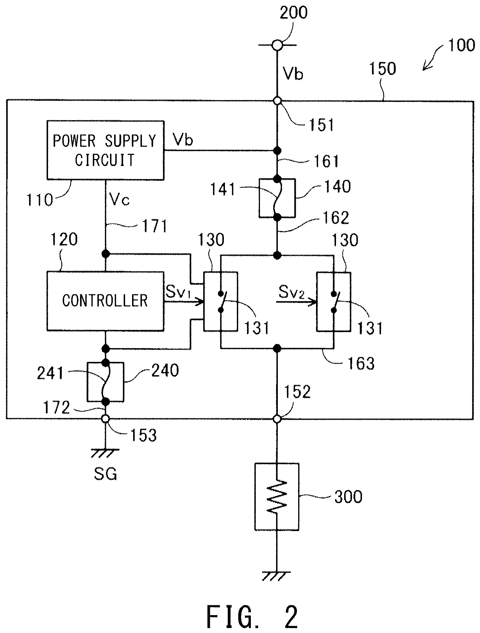

FIG. 2 is a block diagram showing the circuit configuration of the control apparatus 100 shown in FIG. 1. A power supply input terminal 151, a load connection terminal 152, and a signal ground terminal 153 are provided on the printed circuit board 150. A predetermined external power supply voltage Vb (DC voltage) is supplied to the power supply input terminal 151 from an external battery 200. This external power supply voltage Vb is supplied to the power supply circuit 110 and the thermal fuse 140 through a wiring trace 161 for external power supply.

The power supply circuit 110 produces, from the external power supply voltage Vb, a control power supply voltage Vc supplied to the controller IC 120 and control circuits (not shown) within the switch ICs 130. This control power supply voltage Vc is supplied to various control circuits disposed on the printed circuit board 150 through a wiring trace 171 for power supply. The various circuits, including the controller IC 120, are electrically connected to the signal ground terminal 153 of the printed circuit board 150 through the current fuse 240 and a wiring trace 172 for signal ground. This wiring trace 172 is wiring for connecting the various circuits to a signal ground SG, and is also referred to as the "signal ground connection wiring 172." Neither a passive element nor an active element is present between the signal ground SG and the signal ground connection wiring 172. Therefore, the signal ground connection wiring 172 is a wiring line which is connected to the signal ground SG through only a wiring trace whose impedance is ignorable. The signal ground terminal 153 is connected to the signal ground SG provided on the printed circuit board 150 or outside the printed circuit board 150. Notably, in the case where the signal ground SG is realized by a wiring trace provided on the printed circuit board 150, the signal ground terminal 153 may be omitted. Also, the signal ground connection wiring 172 itself may be configured as a large wiring trace which functions as the signal ground SG.

The output terminal of the thermal fuse 140 is electrically connected to the current input terminals of the two switch ICs 130 through a first wiring trace 162 for current path. This wiring trace 162 corresponds to a current path trace on the high side (high voltage side) of the semiconductor switch 131 within each switch IC 130. The current output terminals of the two switch ICs 130 are electrically connected to the load connection terminal 152 of the printed circuit board 150 through a second wiring trace 163 for current path. This wiring trace 163 corresponds to a current path trace on the low side (low voltage side) of the semiconductor switch 131 within each switch IC 130. The load connection terminal 152 is connected to the input terminal of a resistive load 300 (e.g., a glow plug) of an automobile. The output terminal of the resistive load 300 is grounded. In this configuration, the semiconductor switches 131 of the switch ICs 130 are used to drive the resistive load 300 on the high side thereof. Notably, three or more switch ICs 130 may be provided in parallel.

The controller IC 120 turns on and off the two semiconductor switches 131 by supplying control signals Sv1 and Sv2 to the two switch ICs 130, to thereby energize and de-energize the resistive load 300. Notably, in the case where each switch IC 130 includes an FET gate drive circuit for driving the semiconductor switch 131, the control signals Sv1 and Sv2 supplied from the controller IC 120 may be signals each indicating a duty ratio used in PWM control.

The thermal fuse 140 is an overheat prevention component including a passive element 141 for preventing overheating of the switch IC 130. When the temperature of a switch IC 130 rises excessively due to a failure or a malfunction, the electrical connection within the thermal fuse 140 is broken as a result of the temperature rise, whereby current is interrupted. Heat is conducted from the switch ICs 130 to the thermal fuse 140 through mainly the wiring trace 162 between the switch ICs 130 and the thermal fuse 140. The passive element 141 of the thermal fuse 140 may be an element having a structure in which, when solder joining the electrical contacts of the passive element 141 melts as a result of a temperature rise, the electrical contacts are separated from each other through use of mechanical stress produced by a spring or the like. A coil spring or the like may be used as a spring which produces such mechanical stress. However, in FIG. 2, for convenience of depicting, the passive element 141 of the thermal fuse 140 is depicted as a simple fusible fuse. Notably, in the present embodiment, the resistive load 300 of the control apparatus 100 is a glow plug. Therefore, it is preferred to use, as the thermal fuse 140, a thermal fuse through which a large current for the glow plug can be caused to flow. Specifically, it is preferred that the thermal fuse 140 have an interrupting current (or a maximum rush current) of 200 A or greater. In this case, overheating of a plurality of switch ICs can be prevented through use of a single thermal fuse 140.

The current fuse 240 is an overcurrent prevention component including a passive element 241 for preventing overcurrent from flowing to the signal ground connection wiring 172 and the signal ground terminal 153. It is preferred that no passive element or active element be connected between the current fuse 240 and the signal ground terminal 153.

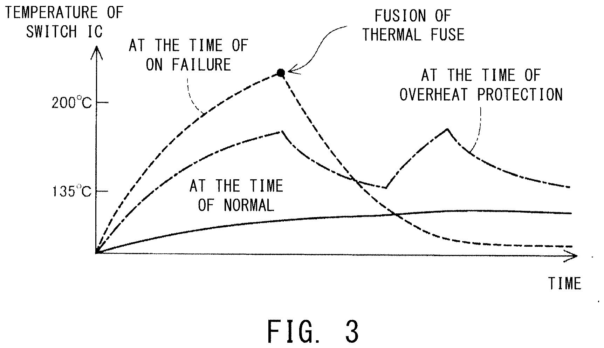

FIG. 3 is an explanatory graph showing an example of change in the temperature of a switch IC. In FIG. 3, the horizontal axis represents time, and the vertical axis represents the temperature of the switch IC. A solid line shows a temperature change at the time of normal operation. In the present embodiment, the control circuit within each switch IC 130 controls the corresponding semiconductor switch 131 by PWM control. At the time of normal operation, when a current flows through the resistive load 300 as a result of the PWM control, the temperature of the switch IC 130 rises gradually. However, the temperature of the switch IC 130 does not rise excessively. A chain line shows a temperature change in the case where, although the temperature of the switch IC 130 rises more quickly as compared with that at the time of normal operation due to a certain cause, the overheat protection circuit within the switch IC 130 operates to thereby prevent overheating of the switch IC 130. A dashed line shows a temperature change in the case where the semiconductor switch 131 of the switch IC 130 breaks and remains in the on state (ON failure). In this case, since the temperature of the switch IC 130 rises excessively, the thermal fuse 140 fuses and the current supplied to the switch IC 130 is interrupted.

In the above-described control apparatus 100, since the single thermal fuse 140 provides overheat protection for the plurality of switch ICs 130, the configuration of the entire control apparatus 100 can be simplified. In particular, as shown in FIG. 2, in the case where the thermal fuse 140 is in common connection with the high sides of the plurality of switch ICs 130, the following advantageous effect is attained. Namely, when the semiconductor switch 131 of one switch IC 130 breaks, there arises a possibility that an unintended current path is formed between the broken semiconductor switch 131 and the signal ground terminal 153 and an overcurrent flows therethrough. Even in such a case, if the thermal fuse 140 is in common connection with the high sides of the plurality of switch ICs 130, the current path through which such a large current flows to the plurality of switch ICs 130 can be cut off through fusion of the thermal fuse 140. As a result, the current flowing through the plurality of switch ICs 130 can be reliably interrupted by the thermal fuse 140.

Also, in the above-described control apparatus 100, the current fuse 240 prevents overcurrent from flowing to the signal ground connection wiring 172 and the signal ground terminal 153.

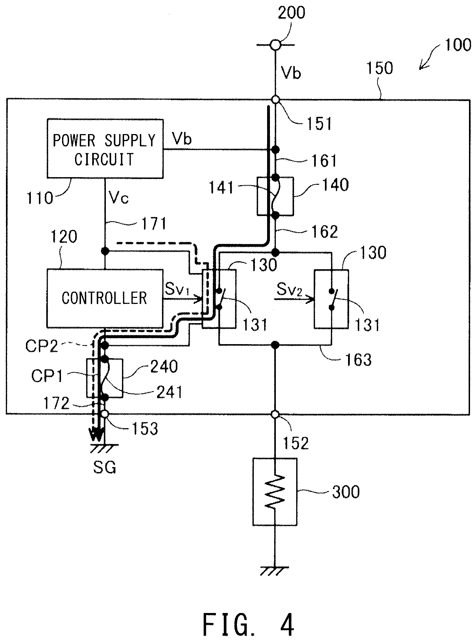

FIG. 4 shows a state in which a current path CP1 through which overcurrent may flow is formed in the control apparatus 100 of FIG. 2. In FIG. 4, there is schematically depicted a case where the semiconductor switch 131 of one switch IC 130 breaks, and a current path CP1 extending from the high side of the semiconductor switch 131 to the signal ground terminal 153 is formed. In this case, the current path CP1 extending from the broken semiconductor switch 131 to the signal ground terminal 153 can be interrupted by the current fuse 240. Such a current path CP1 may be formed when a short circuit is formed between the wiring trace 162 on the high side of the broken semiconductor switch 131 and the wiring on the signal ground side of the semiconductor switch 131. Also, when the insulating layer of the printed circuit board 150 located below the broken semiconductor switch 131 is carbonized, such a current path CP1 may be formed through a carbonized portion. In the present embodiment, since the current fuse 240 is connected to the signal ground connection wiring 172, it is possible to prevent excessively large current from flowing along such a current path CP1. The current interruption effect achieved by the current fuse 240 is remarkable in the case where the insulating layer of the printed circuit board 150 is carbonized, and a current path CP is formed between the wiring trace 161 on the high side of the thermal fuse 140 and the signal ground connection wiring 172. In such a case, although the thermal fuse 140 cannot interrupt current, the current fuse 240 can interrupt current. Notably, another current path CP2 may be formed such that it extends from the wiring trace 171-which supplies the control power supply voltage Vc from the power supply circuit 110 to the various circuits-to the signal ground terminal 153 through the semiconductor switch 131. In this case as well, current can be interrupted by the current fuse 240.

As described above, in the above-described control apparatus 100, even in the case where an unintended current path CP1, CP2 is formed between the current path trace for supplying the power supply voltage Vb or Vc and the signal ground connection wiring 172 of the printed circuit board 150 as a result of failure or breakage of the semiconductor switch 131, overcurrent is interrupted by the current fuse 240. Therefore, it is possible to prevent overcurrent from flowing to the signal ground. Also, since the single thermal fuse 140 provides overheat protection for the plurality of switch ICs 130, the configuration of the entire control apparatus can be simplified, an excess increase in the area of the printed circuit board can be presented. In particular, in the case where the thermal fuse 140 is connected to the high sides of the plurality of switch ICs 130, the current flowing through the switch ICs 130 can be interrupted without fail even when an unintended current path is formed between a broken switch IC 130 and the signal ground connection wiring 172.

### B. Preferred Positional Relation between Switch ICs and Thermal Fuse

In the case where a single thermal fuse 140 is used as a overheat prevention component common among a plurality of switch ICs 130 as shown in FIG. 1, the positional relation between the plurality of switch IC 130 and the thermal fuse 140 is important. Namely, in order to prevent overheating of the individual switch ICs 130 to the same degree, it is desired to dispose the individual switch ICs 130 in positions as close to the thermal fuse 140 as possible. For example, it is preferred that the shortest distance between the perimeter of each switch IC 130 and the perimeter of the thermal fuse 140 be smaller than the dimension L2 of the switch IC 130 in the longitudinal direction and the dimension W2 of the switch IC 130 in the width direction. More specifically, it is preferred that the shortest distance between the perimeter of each switch IC 130 and the perimeter of the thermal fuse 140 be equal to or less than 15 mm, more preferably, equal to or less than 10 mm. Also, it is preferred that the two switch ICs 130 be disposed in symmetry with respect to, for example, the thermal fuse 140. In the case where the individual switch ICs 130 are disposed at positions whose closeness to the thermal fuse 140 are approximately the same as described above, irrespective of which one of the switch ICs 130 breaks, overheating of the broken switch IC 130 can be prevented to the same degree through fusion of the thermal fuse 140. Notably, as will be described below, there can be employed various positional relations between the plurality of switch ICs 130 and the thermal fuse 140.

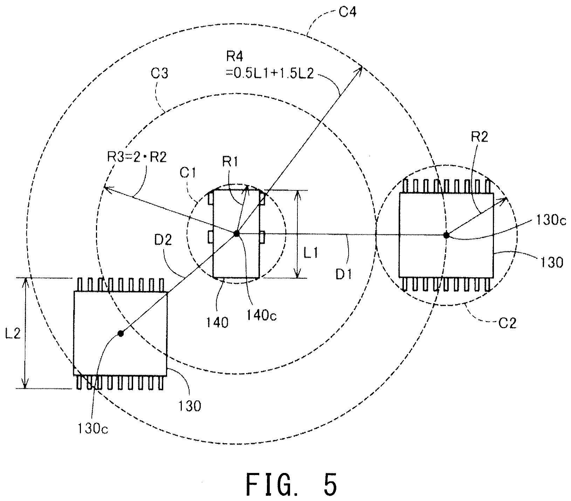

FIG. 5 is an explanatory view showing an example of a preferred layout condition of the switch ICs 130 and the thermal fuse 140. In this example, the following dimensions are employed.
(1) R1: the radius of a circumscribed circle C1 of the thermal fuse 140
(2) R2: the radius of a circumscribed circle C2 of each switch IC 130 (usually, R1 < R2)
(3) L1: the dimension of the thermal fuse 140 in the longitudinal direction
(4) L2: the dimension of each switch IC 130 in the longitudinal direction
(5) R3: the radius of a circle C3 depicted such that its radius becomes equal to (2·R2)
(6) R4: the radius of a circle C4 depicted such that its radius becomes equal to (0.5·L1 + 1.5·L2)
(7) D1, D2: the distance (inter-center distance) between the center 140c of the thermal fuse 140 and the center 130c of each switch IC 130

The circumscribed circle C1 of the thermal fuse 140 is a smallest circle which is circumscribed about the contour of the thermal fuse 140 including the mold portion and the lead wires thereof. The center 140c of the thermal fuse 140 is the center of the circumscribed circle C1. The circumscribed circle C2 and the center 130c of each switch IC 130 are also defined in the same manner. The circle C3 is a circle whose center coincides with the center 140c of the thermal fuse 140 and which has a radius (2·R2) twice the radius R2 of the circumscribed circle C2 of the switch IC 130. The circle C4 is a circle whose center coincides with the center 140c of the thermal fuse 140 and which has a radius (0.5·L1 + 1.5·L2) obtained by adding a value which is 1.5 times the dimension L2 of the switch IC 130 in the longitudinal direction to a value which is a half of the dimension L1 of the thermal fuse 140 in the longitudinal direction.

In FIG. 5, it is preferred that each switch IC 130 be disposed such that its center 130c is located within the circle C4 whose radius is (0.5·L1 + 1.5·L2). In this case, the distance between each switch IC 130 and the thermal fuse 140 becomes relatively short so that at the most one switch IC 130 is disposed therebetween. Therefore, overheating of each switch IC 130 can be prevented properly.

Also, it is preferred that each switch IC 130 be disposed such that its center 130c is located within the circle C3 whose radius is (2·R2). In this case, since the distance between each switch IC 130 and the thermal fuse 140 is limited to a shorter distance, overheating of each switch IC 130 can be prevented more reliably.

Notably, in the case where the center 130c of each switch IC 130 is located within the circle C4 or the circle C3 of FIG. 5, it is not required to equalize the inter-center distances D1 and D2 between the thermal fuse 140 and the switch ICs 130. However, it is preferred that each of the inter-center distances D1 and D2 are set to fall within a range of ±30% of the average of the inter-center distances D1 and D2. In this case, since variation in the distance between each switch IC 130 and the thermal fuse 140 can be reduced, irrespective of which one of the switch ICs 130 breaks, overheating of the broken switch IC 130 can be prevented to the same degree. This applies to the case where the number of switch ICs 130 is three or more. From the viewpoint of reducing variation in the distance between each switch IC 130 and the thermal fuse 140 and variation in the positional relation, it is preferred to dispose the centers 130c of the plurality of switch ICs 130 at positions which are spaced from the center 140c of the thermal fuse 140 by the same amount. In particular, it is further preferred to dispose the plurality of switch ICs 130 at respective positions which are in line symmetry or rotational symmetry with respect to the thermal fuse 140.

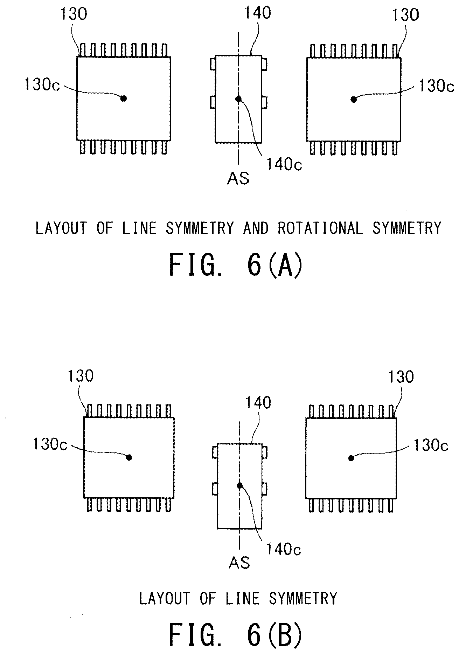

FIGS. 6(A) and 6(B) are explanatory views each showing an example in which two switch ICs 130 are disposed at positions which are in line symmetry/rotational symmetry with respect to a single thermal fuse 140. In the example of FIG. 6(A), the two switch ICs 130 are disposed at positions which are in line symmetry with respect to an axis of symmetry AS passing through the center 140c of the thermal fuse 140. Also, the two switch ICs 130 are disposed at positions which are in rotational symmetry with respect to the center 140c of the thermal fuse 140 and which are located at intervals of 180°. Notably, the entireties of the switch ICs 130 are not required to be in line symmetry and rotational symmetry, so long as at least the centers 130c of the switch ICs 130 are in line symmetry and rotational symmetry with respect to the center 140c of the thermal fuse 140. However, the example of FIG. 6(A) is further preferred, because the entireties of the switch ICs 130 are in line symmetry and rotational symmetry with respect to the center 140c of the thermal fuse 140. In the example of FIG. 6(B), the two switch ICs 130 are disposed at positions which are in line symmetry with respect to the axis of symmetry AS passing through the center 140c of the thermal fuse 140. However, in the example of FIG. 6(B), the two switch ICs 130 are not in rotational symmetry. Notably, the layout examples of FIGS. 6(A) and 6(B) are the same as the example shown in FIG. 1 in the point that the thermal fuse 140 is disposed at a position between the two switch ICs 130.

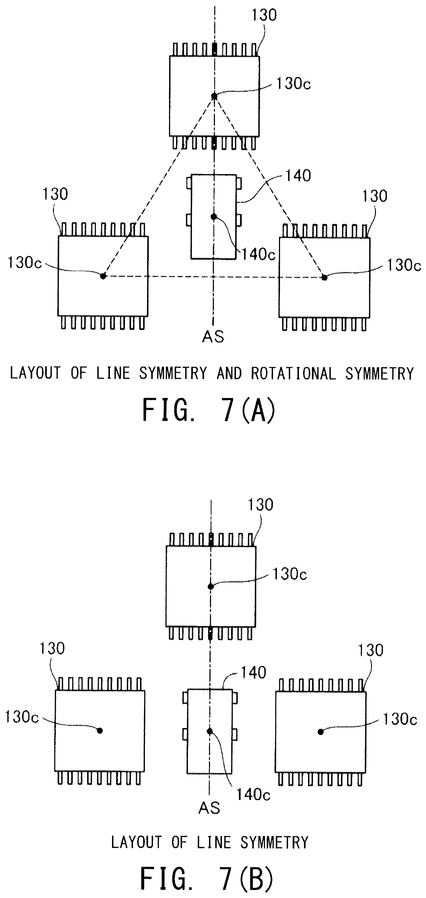

FIGS. 7(A) and 7(B) are explanatory views each showing an example in which three switch ICs 130 are disposed at positions which are in line symmetry/rotational symmetry with respect to a single thermal fuse 140. In the example of FIG. 7(A), the centers 130c of the three switch ICs 130 are disposed at positions which are in line symmetry with respect to an axis of symmetry AS passing through the center 140c of the thermal fuse 140. Also, the centers 130c of the three switch ICs 130 are disposed at positions which are in rotational symmetry with respect to the center 140c of the thermal fuse 140 and which are located at intervals of 120°. In the example of FIG. 7(B), although the three switch ICs 130 are disposed at positions which are in line symmetry with respect to the axis of symmetry AS passing through the center 140c of the thermal fuse 140, the three switch ICs 130 are not in rotational symmetry.

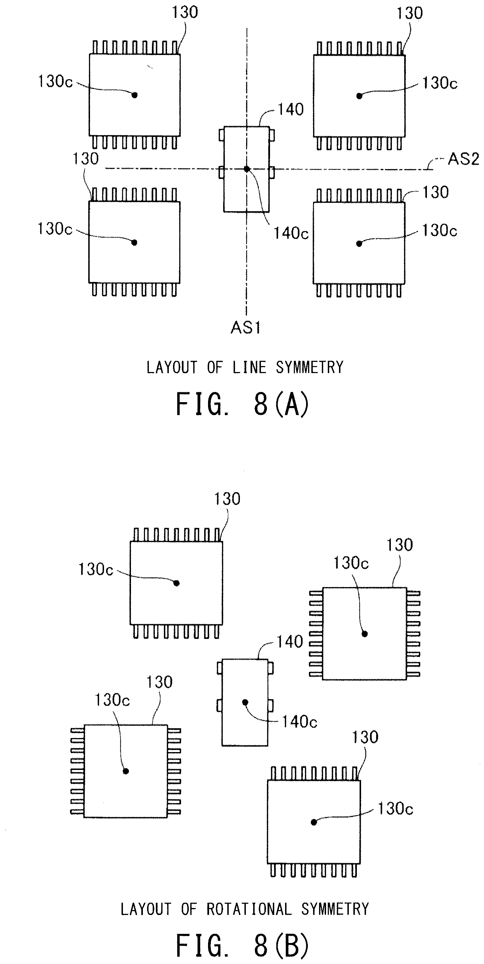

FIGS. 8(A) and 8(B) are explanatory views each showing an example in which four switch ICs 130 are disposed at positions which are in line symmetry or rotational symmetry with respect to a single thermal fuse 140. In the example of FIG. 8(A), the four switch ICs 130 are disposed at positions which are in line symmetry with respect to two axes of symmetry AS1 and AS2 passing through the center 140c of the thermal fuse 140. In the example of FIG. 8(B), the centers 130c of the four switch ICs 130 are disposed at positions which are in rotational symmetry with respect to the center 140c of the thermal fuse 140 and which are located at intervals of 90°.

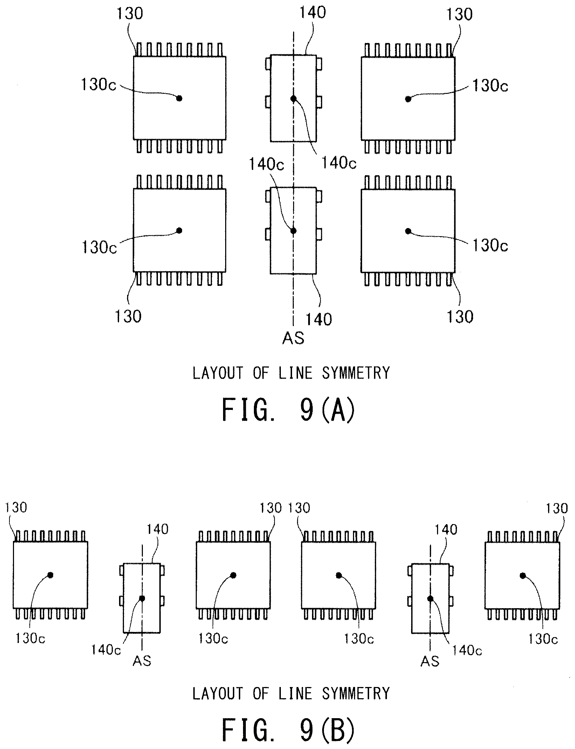

FIGS. 9(A) and 9(B) are explanatory views each showing an example in which four switch ICs 130 are disposed at positions which are in line symmetry with respect to two thermal fuses 140. In the example of FIG. 9(A), two thermal fuses 140 are disposed at the center, and two switch ICs 130 are disposed on the left and right sides of the thermal fuses 140. These four switch ICs 130 are disposed at positions which are in line symmetry with respect to an axis of symmetry AS passing through the centers 140c of the two thermal fuses 140. In the example of FIG. 9(B), a single thermal fuse 140 is disposed at the center of each pair of two switch ICs 130. Also, the two switch ICs 130 present on the opposite sides of the single thermal fuse 140 are disposed at positions which are in line symmetry with respect to an axis of symmetry AS passing through the center 140c of the thermal fuse 140. In FIGS. 9(A) and 9(B), each of the two thermal fuses 140 provides overheat protection for two switch ICs 130 located on the left and right sides thereof. In these cases, in the block diagram of FIG. 2, a circuit including two sets each of which is composed of a single thermal fuse 140 and two switch ICs 130 and which are connected in parallel is formed between the power supply input terminal 151 and the load connection terminal 152.

In the case where a plurality of switch ICs 130 are disposed at positions which are in line symmetry or rotational symmetry with respect to a thermal fuse 140 as shown in FIGS. 6(A) and 6(B) through FIGS. 9(A) and 9(B), the effect of preventing overheating of a broken or failed switch IC 130 to the same degree becomes particularly remarkable. Notably, even in the case where such a layout of line or rotational symmetry is employed, it is preferred to satisfy the positional relation between the switch ICs 130 and the thermal fuse 140 described with reference to FIGS. 1 and 5.

In consideration of the above-described various layouts, it is preferred that the layout of the switch ICs 130 and the thermal fuse(s) 140 satisfy one or more of the following conditions.

### <Layout condition 1>

Switch ICs 130 and a thermal fuse 140 which provides overheat protection for the switch ICs 130 have a positional relation such that no switch IC 130 is present between any of the switch ICs 130 and the thermal fuse 140 (FIG. 1 and FIG. 5 though FIGS. 9(A) and 9(B)).

### <Layout condition 2>

The shortest distance between the perimeter of each switch IC 130 and the perimeter of the thermal fuse 140 is smaller than the dimension L2 of each switch IC 130 in the longitudinal direction (FIG. 1).

### <Layout condition 3>

The shortest distance between the perimeter of each switch IC 130 and the perimeter of the thermal fuse 140 is smaller than the dimension W2 of each switch IC 130 in the lateral direction (FIG. 1).

### <Layout condition 4>

The center 130c of each switch IC 130 is disposed to be located within the circle C4 whose center coincides with the center 140c of the thermal fuse 140 and whose radius is (0.5·L1 + 1.5·L2) (FIG. 5). L1 is the dimension of the thermal fuse 140 in the longitudinal direction, and L2 is the dimension of each switch IC 130 in the longitudinal direction.

### <Layout condition 5>

The center 130c of each switch IC 130 is disposed to be located within the circle C3 whose center coincides with the center 140c of the thermal fuse 140 and whose radius is (2·R2) (FIG. 5). R2 is the radius of the circumscribed circle C2 of each switch IC 130.

### <Layout condition 6>

The plurality of switch ICs 130 and the thermal fuse 140 are disposed in such a manner that the inter-center distances D1, D2 ··· between the plurality of switch ICs 130 and the thermal fuse 140 fall within the range of ±30% of the average of the inter-center distances (FIG. 5).

### <Layout condition 7>

The plurality of switch ICs 130 are disposed at positions which are in rotational symmetry or line symmetry with respect to the thermal fuse 140 (FIGS. 6(A) and 6(B) through FIGS. 9(A) and 9(B))

### <Layout condition 8>

The shortest distance between each switch IC 130 and the thermal fuse 140 is equal to or less than 15 mm, or is equal to or less than 10 mm.

Notably, these layout conditions 1 through 8 are conditions when the switch ICs 130 and the thermal fuse 140 are projected in the thickness direction of the printed circuit board 150.

In the case where, as described in the above-mentioned layout condition 1, the plurality of switch ICs 130 are disposed in such a manner that no switch IC 130 is present between any of the switch ICs 130 and the thermal fuse 140, irrespective of which one of the switch ICs 130 breaks, overheating of the broken switch IC 130 can be prevented to substantially the same degree by the thermal fuse 140. Further, when the plurality of switch ICs 130 are disposed to satisfy one or more of the above-mentioned various layout conditions 2 through 8, overheating of each broken switch IC 130 can be prevented more properly.

### C. Oher Embodiments

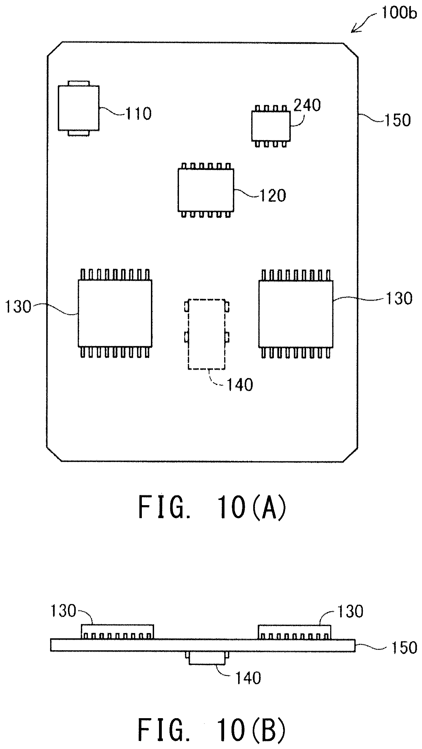

FIGS. 10(A) and 10(B) are plan and front views of a control apparatus 100b which is another embodiment of the present invention. The difference from the control apparatus 100 shown in FIG. 1 is only that, in the control apparatus 100b shown in FIGS. 10(A) and 10(B), a thermal fuse 140 is disposed on the back surface of a printed circuit board 150, and the remaining configuration is the same as the control apparatus 100 shown in FIG. 1. The control apparatus 100b shown in FIGS. 10(A) and 10(B) also yields effects substantially the same as those of the control apparatus 100 shown in FIG. 1. Also, since the switch ICs 130 and the thermal fuse 140 are disposed on different surfaces of the printed circuit board 150, the degree of freedom of layout increases, and the area of the printed circuit board 150 can be decreased.

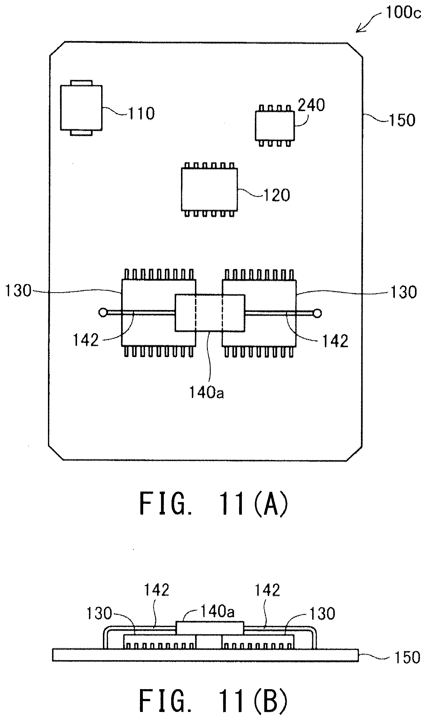

FIGS. 11(A) and 11(B) are plan and front views of a control apparatus 100c which is still another embodiment of the present invention. The difference from the control apparatus 100b shown in FIGS. 10(A) and 10(B) is only that, in the control apparatus 100c shown in FIGS. 11(A) and 11(B), two switch ICs 130 are disposed on a printed circuit board 150 such that they are located adjacent to each other, and that a thermal fuse 140a is disposed in a state in which it is in contract with the mold portions of the two switch ICs 130. The remaining configuration is the same as the control apparatus 100b shown in FIGS. 10(A) and 10(B). The lead wires 142 of the thermal fuse 140a are connected to pads of the printed circuit board 150 in a state in which the lead wires 142 extend over the switch ICs 130. This thermal fuse 140a is a so-called axial component. The control apparatus 100c shown in FIGS. 11(A) and 11(B) also yields effects substantially the same as those of the control apparatus 100 shown in FIG. 1 and the control apparatus 100b shown in FIGS. 10(A) and 10(B).

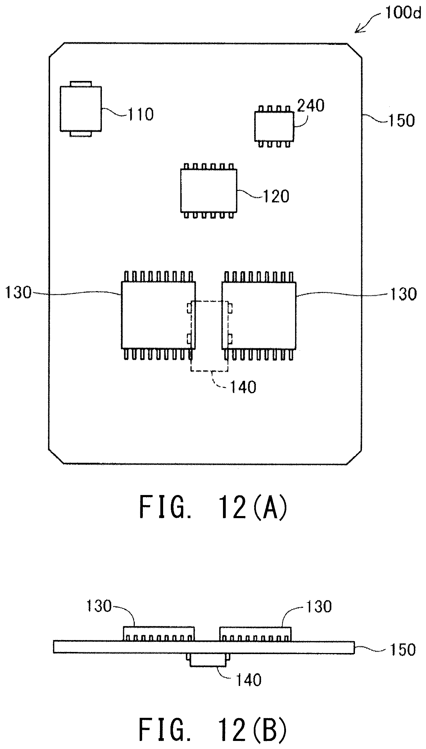

FIGS. 12(A) and 12(B) are plan and front views of a control apparatus 100d which is still another embodiment of the present invention. The difference from the control apparatus 100c shown in FIGS. 11(A) and 11(B) is only that, in the control apparatus 100d shown in FIGS. 12(A) and 12(B), a surface-mount-type thermal fuse 140 which is the same as that used in the control apparatus 100 shown in FIG. 1 is disposed on the back surface of a printed circuit board 150. The remaining configuration is the same as the control apparatus 100c shown in FIGS. 11(A) and 11(B).

In the embodiments shown in FIGS. 11(A) and 11(B) and FIGS. 12(A) and 12(B), when the plurality of switch ICs 130 and the thermal fuse 140a (or 140) are projected in the thickness direction of the printed circuit board 150, the plurality of switch ICs 130 and the thermal fuse 140a (or 140) are disposed such that the contour of the thermal fuse 140a (or 140) and the contour of each switch IC 130 partially overlap with each other. In this case, since the spatial distance between each switch IC 130 and the thermal fuse 140 decreases, overheating of each switch IC 130 can be prevented more effectively.

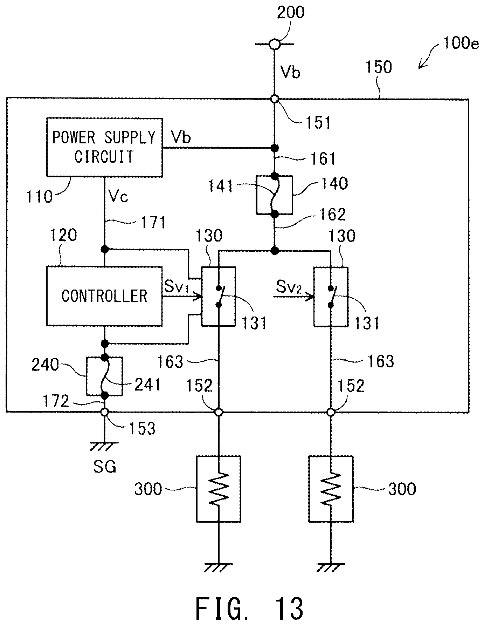

FIG. 13 is a block diagram showing the configuration of a control apparatus 100e which is still another embodiment of the present invention. The difference from the control apparatus 100 shown in FIG. 2 is only that, in the control apparatus 100e shown in FIG. 13, the output terminals of the individual switch ICs 130 are connected to different resistive loads 300 via different load connection terminals 152 provided on the printed circuit board 150, and the remaining structure is the same as the control apparatus 100 shown in FIG. 2. As described above, the individual switch ICs 130 may be used to drive the different resistive loads 300. In this case as well, since the thermal fuse 140 is in common connection with the plurality of switch ICs 130, the thermal fuse 140 can perform overheat protection for the plurality of switch ICs 130.

### D. Modifications

Notably, the present invention is not limited to the above-described examples and embodiments, and may be implemented in various forms without departing from the scope of the invention.

### First modification:

In the above-described embodiment, the thermal fuse 140 which includes a passive element having a function of interrupting current in response to temperature rise is used as an overheat prevention component. However, alternatively, there may be used an overheat prevention component which includes a passive element having a function of limiting current in response to temperature rise. For example, an overheat prevention component using a PTC thermistor can be used as the latter overheat prevention component.

### Second modification:

In the above-described embodiment, the thermal fuse 140 is connected to the high side of the switch IC 130. However, the thermal fuse 140 may be connected to the low side of the switch IC 130.

### [Description of Reference Numerals]

100, 100b to 100e: control apparatus
102: power supply input terminal
110: power supply circuit
120: controller IC
130: switch IC
131: semiconductor switch
140, 140a: thermal fuse
141: passive element
142: lead wire
150: printed circuit board
151: power supply input terminal
152: load connection terminal
153: signal ground terminal
161, 162, 163: wiring trace
171: wiring trace
172: signal ground connection wiring
200: battery
240: current fuse (overcurrent prevention component)
241: passive element
300: resistive load

## Claims

1. A control apparatus (100) in which a switch IC (130) is disposed on a printed circuit board (150), the switch IC (130) being an IC package including a semiconductor switch (131) and being provided on a high-voltage side of a glow plug (300) so as to drive the glow plug (300), and the printed circuit board (150) having a signal ground connection wiring (172) formed thereon,
the control apparatus (100) being **characterized by** comprising:
an overheat prevention component (140) which is connected to the switch IC (130) and which includes a first element (141) having a function of interrupting or limiting current flowing through the switch IC (130) in response to temperature rise; and
an overcurrent prevention component (240) which is connected to the signal ground connection wiring (172) and which includes a second element (241) having a function of interrupting overcurrent.

2. A control apparatus (100) according to claim 1, wherein a plurality of the switch ICs (130) are disposed on the printed circuit board (150) such that no switch IC is present between any of the switch ICs (130) and the overheat prevention component (140).

3. A control apparatus (100) according to claim 2, wherein, when the plurality of switch ICs (130) and the overheat prevention component (140) are projected in a thickness direction of the printed circuit board (150), the plurality of switch ICs (130) are disposed such that the center (130c) of each switch IC (130) is present within a circle (C4) whose center coincides with the center (140c) of the overheat prevention component (140) and whose radius is (0.5 L1 + 1.5·L2), where L1 is the dimension of the overheat prevention component (140) in the longitudinal direction thereof, and L2 is the dimension of each switch IC (130) in the longitudinal direction thereof.

## Patentansprüche

1. Steuervorrichtung (100), bei der ein Schalter-IC (130) auf einer Leiterplatte (150) angeordnet ist, wobei der Schalter-IC (130) ein IC-Paket ist, das einen Halbleiterschalter (131) enthält und das auf einer Hochspannungsseite einer Glühkerze (300) vorgesehen ist, um die Glühkerze (300) zu betreiben, und die Leiterplatte (150) eine darauf ausgebildete Signalmassenverbindungsverdrahtung (172) aufweist,
wobei die Steuervorrichtung (100) **dadurch gekennzeichnet ist, dass** sie umfasst:
eine Überhitzungsverhinderungskomponente (140), die mit dem Schalter-IC (130) verbunden ist und die ein erstes Element (141) mit einer Funktion zum Unterbrechen oder Begrenzen des durch den Schalter-IC (130) als Reaktion auf den Temperaturanstieg fließenden Stroms aufweist; und
eine Überstromverhinderungskomponente (240), die mit der Signalmassenverbindungsverdrahtung (172) verbunden ist und die ein zweites Element (241) mit einer Funktion zum Unterbrechen des Überstroms enthält.

2. Steuervorrichtung (100) nach Anspruch 1, wobei eine Mehrzahl von Schalter-ICs (130) auf der Leiterplatte (150) angeordnet sind, so dass kein Schalter-IC zwischen einem der Schalt-ICs (130) und der Überhitzungsverhinderungskomponente (140) vorgesehen ist.

3. Steuervorrichtung (100) nach Anspruch 2, wobei die Mehrzahl von Schalter-ICs (130) und die Überhitzungsverhinderungskomponente (140) in einer Dickenrichtung der Leiterplatte (150) hervorstehen, die Mehrzahl von Schalter-ICs (130) so angeordnet sind, dass die Mitte (130c) jedes Schalter-ICs (130) innerhalb eines Kreises (C4) vorgesehen ist, dessen Mittelpunkt mit dem Zentrum (140c) der Überhitzungsverhinderungskomponente (140) zusammenfällt und dessen Radius (0,5 • L1 + 1,5 • L2) beträgt, wobei L1 die Abmessung der Überhitzungsverhinderungskomponente (140) in deren Längsrichtung ist, und L2 die Abmessung jedes Schalter-IC (130) in dessen Längsrichtung ist.

## Revendications

1. Appareil de commande (100) dans lequel un circuit intégré à commutateur (IC) (130) est disposé sur une carte de circuit imprimé (150), le circuit intégré à commutateur (130) étant un boîtier de circuit intégré incluant un commutateur à semiconducteur (131) et étant prévu sur un côté à haute tension d'une bougie de préchauffage (300) de manière à actionner la bougie de préchauffage (300), et la carte de circuit imprimé (150) comportant un branchement de mise à la terre (172) formé sur celle-ci,
l'appareil de commande (100) étant **caractérisé en ce qu'**il comprend :
un composant de prévention de surchauffe (140) qui est connecté au circuit intégré à commutateur (130) et qui inclut un premier élément (141) ayant une fonction d'interruption ou de limitation du courant circulant à travers le circuit intégré à commutateur (130) en réponse à une augmentation de la température ; et
un composant de prévention de surtension (240) qui est connecté au branchement de mise à la terre (172) et qui inclut un second élément (241) ayant une fonction d'interruption de surtension.

2. Appareil de commande (100) selon la revendication 1, où une pluralité de circuits intégrés à commutateur (130) est disposée sur la carte de circuit imprimé (150) de telle manière qu'aucun circuit intégré à commutateur n'est présent entre aucun des circuits intégrés à commutateur (130) et le composant de prévention de surchauffe (140).

3. Appareil de commande (100) selon la revendication 2, où, lorsque la pluralité de circuits intégrés à commutateur (130) et le composant de prévention de surchauffe (140) sont projetés dans une direction de l'épaisseur de la carte de circuit imprimé (150), la pluralité de circuits intégrés à commutateur (130) est disposée de manière à ce que le centre (130c) de chaque circuit intégré à commutateur (130) se trouve à l'intérieur d'un cercle (C4) dont le centre coïncide avec le centre (140c) du composant de prévention de surchauffe (140) et dont le rayon est (0,5xL1 + 1,5xL2), où L1 est la dimension du composant de prévention de surchauffe (140) dans sa direction longitudinale, et L2 est la dimension de chaque circuit intégré à commutateur (130) dans sa direction longitudinale.
